## Europäisches Patentamt
## European Patent Office
## Office européen des brevets

(11) Publication number: **0 208 487**
**A2**

# EUROPEAN PATENT APPLICATION

(21) Application number: 86305043.1

(22) Date of filing: 27.06.86

(51) Int. Cl.⁴: **C23C 14/14 , C23C 14/34**

(30) Priority: 01.07.85 GB 8516580
01.11.85 GB 8526947

(43) Date of publication of application:
14.01.87 Bulletin 87/03

(84) Designated Contracting States:
**CH DE FR IT LI SE**

(71) Applicant: **UNITED KINGDOM ATOMIC ENERGY AUTHORITY**
**11 Charles II Street**
**London SW1Y 4QP(GB)**

(72) Inventor: **Warrington, Philip**
**48 North Drive**
**Harwell Oxn(GB)**
Inventor: **Coad, Joseph Paul**
**Rosedalen 24 Craven Common**
**Uffington Oxon(GB)**
Inventor: **Restall, James Edward**
**18 Alphington Avenue**
**Frimley Camberley Surrey(GB)**
Inventor: **Rickerby, David Stafford**
**15 Catmore Close**
**Grove Wantage Oxon(GB)**

(74) Representative: **Mansell, Keith Rodney**
**Patents Branch United Kingdom Atomic Energy Authority 11 Charles II Street**
**London SW1Y 4QP(GB)**

(54) **Coating improvements.**

(57) A coating is formed on a substrate by sputter ion plating wherein a DC glow discharge is génerated under soft vacuum conditions in the presence of the substrate and of a cathode constituted by the coating material thereby to release material at the cathode by ion bombardment, which released material diffuses to the substrate to form the coating thereon, and wherein a potential is applied to the substrate during coating.

The coating material comprises a MCrAlSi allow (where M is a single metal or combination of metals selected from the group consisting of nickel, cobalt and iron) and the potential is in the form of an AC bias in order to control the properties of the coating. It is thereby possible to coat uniformly subtrates having sharp edges such as aerofoil components. Moreover, the coatings are found to possess outstanding corrosion resistance properties.

## Coating Improvements

This invention relates to the coating of substrates by sputter ion plating.

Sputter ion plating is a known coating technique and involves the transfer of material from a cathode to a substrate in the presence of a DC glow discharge in a soft vacuum chamber wherein the material is generated from the cathode by the action of ion bombardment, i.e. sputtering, and ultimately diffuses to the substrate to form a coating thereon. Sputter ion plating is described in detail in a number of references in the art, for example in Proc. conf. on 'Ion plating and Allied Techniques', Edinburgh, 1977, CEP Consultants, Edinburgh, 177 by R.A. Dugdale; Metals Technology 1982, 9, 499 by J.P. Coad and J.E. Restall; and NATO Advanced Workshop on "Coatings for Heat Engines', Acquafredda di Maratea, Italy, April 1984 by J.P. Coad and D.S. Rickerby.

In the practice of sputter ion plating, a negative bias voltage may advantageously be applied to the coated substrate to cause densification of the coating by resputtering of deposited material and ion polishing. A negative bias voltage applied in this way may, however, give rise to problems. For example, where the coating material includes Al, which is difficult to control using sputter ion plating, and where the substrate has parts such as edges where the bias field is concentrated, the concentration of Al in the coating produced on those parts is markedly reduced.

The invention is concerned with ameliorating the above-mentioned problem in a specific case and with providing a coating having outstanding resistance to corrosion. It is a method of forming an alloy coating comprising MCrAlSi on a substrate by sputter ion plating, wherein M is a single metal or combination of metals selected from the group consisting of nickel, cobalt and iron, which method comprises generating a DC glow discharge under soft vacuum conditions in the presence of the substrate and of a cathode constituted by the alloy coating material thereby to release material at the cathode by ion bombardment, which released material diffuses to the substrate to form the coating thereon, and, during said coating, applying an AC bias potential to the substrate thereby to control the properties of the coating.

By "MCrAlSi" is meant an alloy consisting essentially of the elements Cr, Al, Si and M as defined above. The alloy may also include minor additions of other ingredients and/or of incidental impurities. The composition of the coating alloy is preferably as follows:

Cr (20 to 40%), Al (6 to 12%), Si (0.5 to 12%) and the balance M, wherein the above percentages (and elsewhere in this specification) are by weight. A particularly preferred composition of the coating alloy is: Cr (30 to 40%), Al 6 to 12%), Si (0.5 to 10%) and the balance M, wherein the alloy 35 Cr-8 Al-8 Si-balance Ni is a particular example.

The waveform of the potential may be of any shape that enables negative voltages to be applied to the substrate for part of the time during which coating is taking place. For example, it may be sinusoidal, rectangular, or any convenient shape. It need not necessarily be of fixed frequency nor of balanced positive and negative amplitude. Use of an AC bias has the advantage that the maximum voltage (which causes the Al to sputter away most readily) is applied for only a fraction of the time. For example, a 240 volts AC supply may be suitable; by choosing the appropriate input phase, the phase of the AC bias may be varied to match the power supply providing the main sputtering power.

The invention is suited to the production of coatings containing elements which have a low threshold energy for sputtering. An example of such an element is aluminium which has been mentioned above.

Examples of substrate materials include metals such as steels (e.g. mild, carbon or stainless), Al and Al base alloys, Ta, Cu, Mo and Ni and Ni base alloys; and ceramics such as silica and alumina. Also, the invention is particularly useful for coating substrates having relatively sharp edges since loss of coating material at such edges may be avoided. Examples of such additional substrates are aerofoil components in gas turbine engines. Of particular value for such applications is the finding that the MCrAlSi coatings of the invention possess outstanding resistance to corrosion.

The composition of the MCrAlSi alloy may be varied within wide limits consistent with its ability to be coated satisfactorily onto the substrate by the method of the invention.

The invention will now be paricularly described by way of example only where reference will be made to the accompanying drawings, the sole figure of which is a schematic diagram of an apparatus for carrying out coating by sputter ion plating.

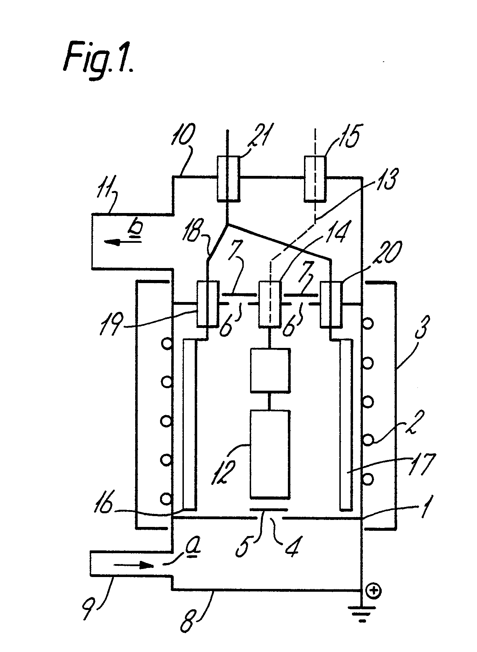

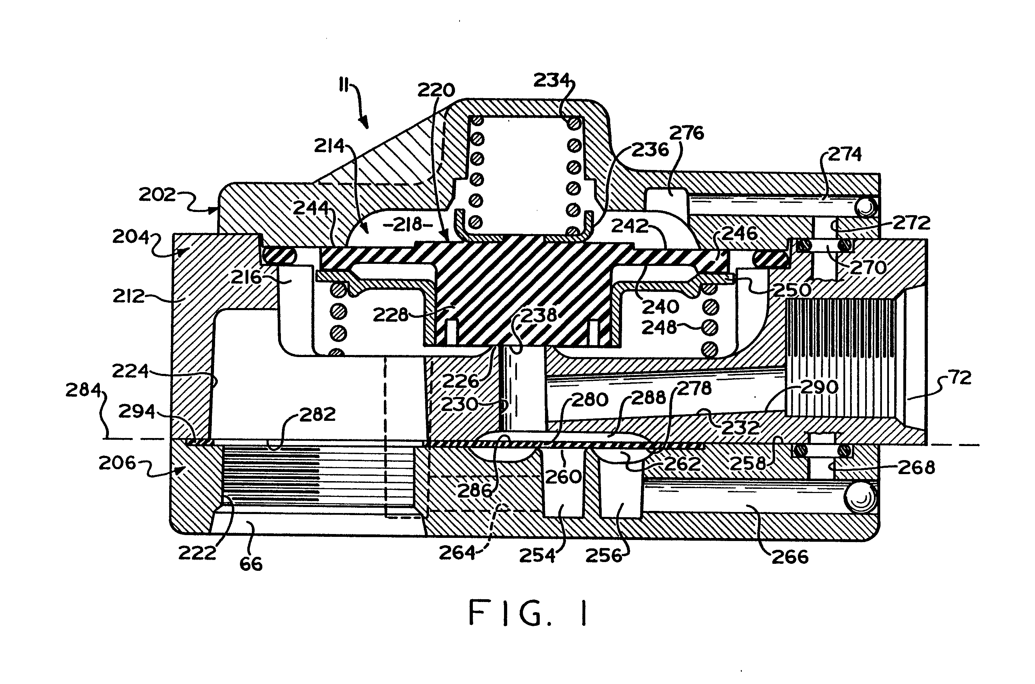

Referring to Figure 1, an earthed cylindrical coating chamber 1 is provided with an externally mounted resistance heater 2 having a cooling jacket 3. The coating chamber 1 has a gas inlet vent 4 with an associated baffle 5 and gas outlet vents 6 with associated baffles 7. The inlet vent 4 communicates with a getter chamber 8 provided with an inlet conduit 9 and the outlet vents 6 communicate with a pumping chamber 10 provided with a pumping port 11.

A substrate 12 is mounted in the coating chamber 1 and is electrically connected to a bias potential power supply (not shown) by a conductor 13 mounted in insulators 14 and 15 positioned in the walls of the pumping chamber 10. A cathode in the form of a series of target plates of which two 16 and 17 are shown is also mounted within the coating chamber 1. The cathode (e.g. 16 and 17) is electrically connected to a cathode power supply (not shown) by a conductor 18 mounted in insulators 19, 20 and 21 positioned in the walls of the pumping chamber 10.

In operation of the apparatus shown in Figure 1, an operating gas is supplied at the inlet conduit 9 and, by operation of a pump (not shown) at the pumping port 11, is drawn into the getter chamber 8 as shown by arrow a and thence into the coating chamber 1 via inlet vent 4. The coating chamber 1 is heated by means of the heater 2 in order to outgas the substrate 12, cathode (e.g. 16 & 17) and evaporate any organic material. Undesired gas and vapour leave the coating chamber 1 via the outlet vents 6 to enter the pumping chamber 10 and are removed via the pumping port 11 as shown by arrow b. A high negative voltage is applied to the target plates (e.g. 16 and 17) by means of the cathode power supply (not shown) to produce a glow discharge with net transfer of cathode material therefrom by sputtering onto the substrate 12 to provide a coating thereon. External heating is not required at this stage since the process generates sufficient power to maintain the operating temperature. An AC bias is applied to the coated substrate 12 thereby produced using the biasing means in order to densify the coating by resputtering of deposited material and ion polishing.

EXAMPLES

General Procedure

The apparatus shown in the Figure was used. The coating chamber 1 was pumped down to 10-100 m torr pressure with a flowing high purity argon atmosphere purified by passing over freshly deposited titanium. The coating chamber 1 was heated to a temperature of around 300°C to effect outgassing of the substrate 12 and the cathode e.g. 16 and 17 and evaporation of any organic material. A high negative voltage (typically 400V to 1500V) was then applied to the cathode e.g. 16 and 17 to produce a glow discharge with net transfer of material therefrom to the substrate 12 to effect coating thereof. An AC bias from a 240V AC supply (10 to 100 volts RMS) was applied to the coated substrate 8 to densify the coating.

Specific Examples

The above procedure was used to coat a substrate having sharp edges with an alloy based on nickel, chromium, aluminium and silicon (a NiCrAlSi alloy) to confer high temperature oxidation and hot corrosion resistance properties, the cathode comprising the NiCrAlSi alloy. The coating was found to be evenly applied and to be of consistent composition even at the edges of the substrate. Specifically, the substrate samples were in the form of turbine blades having sharply radiused edges and the AC bias applied to the samples was 50V AC. The aluminium concentration of the coated samples was measured at an edge thereof where it was found that there was no significant removal of aluminium.

The coated turbine blades were tested for several hundred hours under arduous corrosive conditions in a marine gas turbine engine. At the conclusion of the test, the coating was found to have performed considerably better than commercially available Pt-Al and some proprietary electron beam evaporated CoCrAlY coatings.

**Claims**

1. A method of forming a coating on a substrate by sputter ion plating, which method comprises generating a glow discharge under soft vacuum conditions in the presence of the substrate and a cathode constituted by the coating material thereby to release material at the cathode by ion bombardment, which released material diffuses to the substrate to form the coating thereon, characterised in that the coating comprises an MCrAlSi alloy wherein M is a single metal or combination of metals selected from the group consisting of nickel, cobalt and iron, and, during said coating, an AC bias potential is applied to the substrate thereby to control the properties of the coating.

2. A method according to claim 1 wherein the substrate is a metal substrate.

3. A method according to claim 2 wherein the substrate is an aerofoil component for a gas turbine engine.

4. A method according to any of the preceding claims wherein the MCrAlSi alloy has the composition by weight of 20 to 40% Cr, 6 to 12% Al, 0.5 to 12% Si and the balance M.

5. A method according to claim 4 wherein the alloy has the composition by weight of 30 to 40% Cr, 6 to 12% Al, 0.5 to 10% Si and the balance M.

Fig.1.

FIG. 1

0 208 469